# EUROPEAN PATENT SPECIFICATION

(11) **EP 4 661 233 B1**
(45) Date of publication and mention of the grant of the patent: **09.12.2026**
(21) Application number: 24179811.5
(22) Date of filing: 04.06.2024
(51) Int. Cl.: H02J 3/00, G01R 31/08, H02J 13/00, H02J 13/12, H02J 3/0012

(54) **METHODS, DEVICE AND STORAGE MEDIUM FOR DETERMINING A WAVE SPEED OR PROPAGATION VELOCITY IN A POWER GRID**
VERFAHREN, VORRICHTUNG UND SPEICHERMEDIUM ZUR BESTIMMUNG EINER WELLENGESCHWINDIGKEIT ODER AUSBREITUNGSGESCHWINDIGKEIT IN EINEM STROMNETZ
PROCÉDÉS, DISPOSITIF ET SUPPORT DE STOCKAGE POUR DÉTERMINER UNE VITESSE D'ONDE OU UNE VITESSE DE PROPAGATION DANS UN RÉSEAU ÉLECTRIQUE

(43) Date of publication of application: 10.12.2025
(73) Proprietor: Hitachi Energy Ltd, 8050 Zürich (CH)
(72) Inventor: NAIDU, Obbalareddi Demudu, 560087 Bangalore, Karnataka (IN); VENKATESAN, Aarthi, 600099 Chennai (IN); KRAKOWSKI, Marcin, 04-282 Warszawa (PL)
(74) Representative: Vossius & Partner Patentanwälte Rechtsanwälte mbB

(56) References cited:
- DING JIALI ET AL: "Distributed travelling-wave-based fault location without time synchronisation and wave velocity error", IET GENERATION, TRANSMISSION&DISTRIBUTION, IET, UK, vol. 11, no. 8, 1 June 2017 (2017-06-01), pages 2085 - 2093, XP006062129, ISSN: 1751-8687, DOI: 10.1049/IET-GTD.2016.1778
- ZHANG YIQI ET AL: "Optimal Line Parameter Estimation Method For Mid-Compensated Transmission Lines", 2019 NORTH AMERICAN POWER SYMPOSIUM (NAPS), IEEE, 13 October 2019 (2019-10-13), pages 1 - 6, XP033719452, DOI: 10.1109/NAPS46351.2019.9000274

## Description

The present disclosure relates to methods for determining a wave speed or propagation velocity in a power grid. The disclosure also relates to a corresponding computer-readable storage medium, device and power grid.

In particular, the disclosure relates to a setting-free fault location methodology for power transmission lines with series compensation.

To meet the growing power demand, existing utilities may have installed series capacitors on long transmission lines [1]. The main purpose of series compensation in power systems is a virtual reduction of the line reactance to enhance the power system stability, damping of the power system oscillations, better controllability of the power flow, and enhance the power transfer capability of transmission corridors [1]. However, the parameter estimation and fault location for a series compensated line is one of the most difficult tasks of the intelligent electronic device (IED) manufacturers and utility protection engineers due to the non-linear characteristics of the series capacitor protection unit (e.g., Metal Oxide Varistor (MOV)) [1] in the measurement loop. This makes phasor-based fault location algorithms [2, 3] not reliable for series compensated systems, especially without the measurement across the series capacitor. Thus, a traveling wave-based fault locator may be a reliable solution for series compensated lines. Traveling wave-based fault locators provide good accuracy with an error of few hundreds of meters [2]. However, the fault location accuracy of the reported method [2] required the wave speed as a setting which depends on the line parameters, wherein online parameter estimation of series compensated lines may be difficult due to the non-linear characteristics of a MOV present in the measurement loop.

A setting-free traveling wave-based fault locators are known, e.g., from [3]. However, these methods require a second arrival time which might not be available at all times. A distributed traveling wave-based fault location technique that uses measurements at three locations of the line is proposed in [4] which does not require a wave speed as an input value. It requires measurement devices to be installed at three locations on the line and is therefore not cost-effective. A method to avoid the limitation of wave speed (line parameters) is available in [5] for uncompensated lines. However, this method requires a proper initial guess of the wave speed and approximate latency information of the communication channel. Further, this is a search-based method and depends on the time difference between the first incident traveling waves and the one reflection from the fault point, at both the terminals of the line. The technique may find limited performance for faults close to the terminals of the line due to the requirement of traveling wave arrival times of incident and reflection waves from the fault point, at both ends.

An exemplary line parameter estimation for series compensated lines is proposed in [6, 7]. These methods require measurements across the series compensator. A method to estimate parameters of series compensated lines using multiple sets of SCADA (supervisory control and data acquisition) and phasor measurements unit data is proposed in [8]. The currents from both ends of the compensator are compared and iterative methods are used to compute the parameters. All the phasor-based parameter estimation methods described in [6]-[8] require multiple unique data sets. Moreover, the methods use an iterative approach to solve for line parameters which might not be feasible to implement in IEDs. A method for estimating the parameters of series compensated line using synchronised time-domain data captured by the intelligent electronic devices at both ends of the line, which is free of the compensation model, is presented in [9]. The method uses traveling waves generated during disturbance to obtain the propagation constant of the line, which is used to estimate the resistance and the characteristic impedance of the line. Subsequently, the inductance and capacitance of the line are calculated. However, this method requires the two-traveling wave (incident and reflected waves) arrival times captured at both ends of the line which may not be possible always due to attenuation of the traveling waves.

In view of the above, there is a need for a line parameter estimation and thereby calculation of the wave speed of the series compensated lines. As presented herein, a setting-free fault location of the series compensated lines may be achieved by using the estimated wave speed and first traveling wave arrival times.

Moreover, the present disclosure addresses the need to estimate the line parameters and wave speed of the line without iterative process and multiple unique data sets.

Also, there is a need to estimate the wave speed (line parameters of the series compensated lines), preferably using pre-fault data. The fault location may be computed using the first two traveling wave arrival times from both ends of the series compensated lines. The accuracy of the method presented herein may be independent of the location and level of compensation.

The approaches of the prior art may have limitations when applied to series compensated lines.

The above problems are solved with the features of the present disclosure.

In particular, the present disclosure proposes a parameter estimation for series compensated lines without use of any measurements across series compensator. The method may use both end voltage and current measurements and series capacitor value to estimate the parameters and wave speed of the series compensated line. The method does not involve any iterative approach to estimate the parameters and wave speed of the series compensated line. The estimated wave speed and first traveling wave arrival time is used to calculate an accurate fault location of the series compensated lines. This approach does not require any settings and both fault location and parameters of the line may be achieved as an output.

The invention is specified by the independent claims. Preferred embodiments are defined in the dependent claims. In the following description, although numerous features may be designated as optional, it is nevertheless acknowledged that all features comprised in the independent claims are not to be read as optional.

An aspect of the present disclosure relates to a method for determining a wave speed or propagation velocity in a power grid comprising a transmission line connected between two buses. The method comprises obtaining a voltage and current at at least one bus, determining a propagation constant using the voltage, the current and a series compensator capacitance and determining a wave speed or propagation velocity based on the propagation constant and a frequency of the transmission line.

The present disclosure relates to a method for determining a wave speed or propagation velocity in a power grid comprising a transmission line connected between two buses comprising obtaining a voltage and current at at least one bus, determining a propagation constant and a characteristic impedance using the voltage, the current and a series compensator capacitance, determining line parameters based on the propagation constant and the characteristic impedance and determining a wave speed or propagation velocity based on the line parameters.

Various embodiments may preferably implement the following features.

Preferably, the line parameters comprise a line inductance, a line capacitance, a line resistance and a line conductance.

Preferably, the wave speed is determined based on an inverse square root of the line inductance and the line capacitance.

Preferably, the propagation constant is determined based on a positive sequence current and voltage at the least one bus and a length between the at least one bus and a series compensator capacitance.

Preferably, the method further comprises determining a traveling wave arrival time at at least one of the buses.

Preferably, the method further comprises determining a fault location based on a first travelling wave arrival time, a line length and the wave speed or propagation velocity.

Preferably, the current and voltage measurements comprise pre-fault measurements and/or measurements during the fault.

Preferably, the fault location is determined using current and voltage measurements during the fault.

Preferably, the wave speed or propagation velocity is determined based on pre-fault current and voltage measurements.

The present disclosure also relates to a computer-readable storage medium comprising instructions which, when executed by a processor, instruct the processor to perform the method(s) as outlined above.

The present disclosure also relates to a device comprising a processor configured to perform the method(s) as described above.

The present disclosure also relates to a power grid comprising a transmission line connected between two buses and a device as described above.

Other aspects, features, and advantages will be apparent from the summary above, as well as from the description that follows, including the figures and the claims.

Embodiments of the present disclosure will now be described by way of example only and with reference to the following accompanying drawings. In the figures, the same reference numerals denote the same or similar elements.
Fig. 1 shows a flow chart according to an embodiment of the present disclosure.
Fig. 2 shows a flow chart according to an embodiment of the present disclosure.
Fig. 3 shows a two terminal transmission line with a series compensator according to an embodiment of the present disclosure.
Fig. 4 shows a network system of the configuration according to Fig. 3.
Fig. 5 shows a two terminal transmission line with a series compensator according to an embodiment of the present disclosure.
Fig. 6 shows a network system of the configuration according to Fig. 5.
Fig. 7 shows a two terminal transmission line with two series compensators according to an embodiment of the present disclosure.
Fig. 8 shows a network system of the configuration according to Fig. 7.
Fig. 9 shows a Bewley Lattice diagram of a system according to Fig. 3.

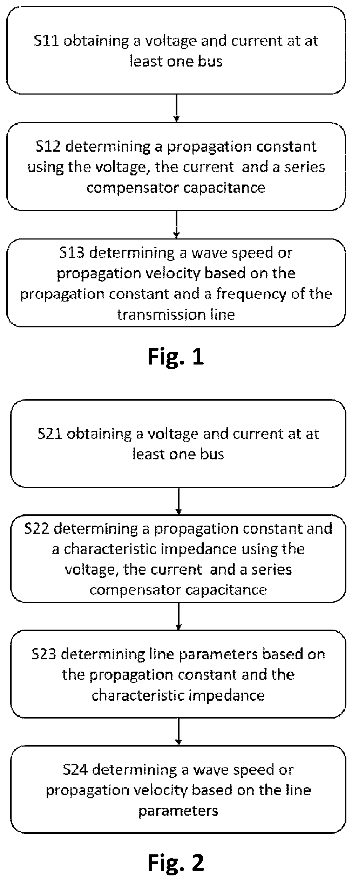

Referring to Fig. 1, an embodiment of the present disclosure relates to a method for determining a wave speed or propagation velocity in a power grid comprising a transmission line connected between two buses. The method comprises obtaining S11 a voltage and current at at least one bus, determining S12 a propagation constant using the voltage, the current and a series compensator capacitance and determining S13 a wave speed or propagation velocity based on the propagation constant and a frequency of the transmission line. The frequency of the transmission line relates to the nominal frequency/operation frequency of the power grid, i.e., a utility frequency/power line frequency/mains frequency.

Referring to Fig. 2, an embodiment of the present disclosure relates to a method for determining a wave speed or propagation velocity in a power grid comprising a transmission line connected between two buses comprising obtaining S21 a voltage and current at at least one bus, determining S22 a propagation constant and a characteristic impedance using the voltage, the current and a series compensator capacitance, determining S23 line parameters based on the propagation constant and the characteristic impedance and determining S24 a wave speed or propagation velocity based on the line parameters.

As used herein, the term obtaining may encompass measuring, determining, computing or receiving values such as voltage and/or current. That is, the method may for example comprise directly measuring certain parameters via at least one sensor or may comprise receiving measurement values from at least one sensor.

Moreover, the term line parameter may comprise line inductance, line capacitance, line resistance and line conductance.

The below is equally applicable to both methods shown in Figs. 1 and 2.

The line parameters may comprise a line inductance, a line capacitance, a line resistance and a line conductance. The wave speed or propagation velocity may be determined based on a square root, in particular an inverse of a square root, of the line inductance and the line capacitance.

Further parameters may comprise a line impedance, a line inductive reactance and/or a line admittance. These parameters may be obtained from the line parameters.

The propagation constant may be determined based on a positive sequence current and voltage at the least one bus and a length between the at least one bus and a series compensator capacitance.

The method may further comprise determining a traveling wave arrival time at at least one of the buses.

The method may further comprise determining a fault location based on a first travelling wave arrival time, a line length and the wave speed or propagation velocity.

The current and voltage measurements may be pre-fault measurements, i.e., measurements that are taken at a point in time at which no fault was present on the transmission line, and/or measurements taken during the fault.

In an embodiment, the fault location may be determined using current and voltage measurements during the fault.

In an embodiment, the wave speed or propagation velocity may be determined based on pre-fault current and voltage measurements.

The present disclosure also relates to a computer-readable storage medium comprising instructions which, when executed by a processor, instruct the processor to perform the method(s) as outlined above. The present disclosure also relates to a device comprising a processor configured to perform the method(s) as described above. The present disclosure also relates to a power grid comprising a transmission line connected between two buses and a device as described above.

In addition to the above, the disclosure will now be described in more detail. Unless indicated otherwise, all embodiments of the present disclosure are fully compatible with one another and certain features may be combined across the different embodiments.

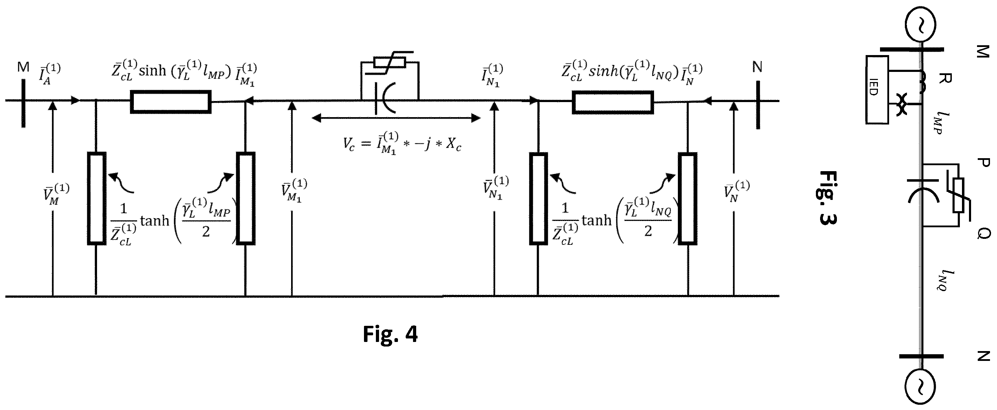

One aim of the present disclosure is to estimate the parameters of the transmission line networks which are connected to series compensators at the middle or at any location from local bus. In Fig. 3, a transmission line with buses M and N as well as a series compensator between points P and Q is shown. In other words, the compensator provided at a length *l_{MP}* from bus M is shown. The length between the series compensator and bus N is indicated by the length *l_{NQ}.* An IED is connected at point R₁.

A pre-fault network for the system shown in Fig. 3 is exemplarily shown in Fig. 4.

From Fig. 4, the voltage drop at the line before the series capacitor from bus M and bus N can be computed as in equations (1) and (2), respectively. ${\overline{V}}_{{M}_{1}}^{\left(1\right)} = {\overline{V}}_{M}^{\left(1\right)} cosh \left({\overline{γ}}_{L}^{\left(1\right)}{l}_{MP}\right) - {\overline{I}}_{M}^{\left(1\right)} {\overline{z}}_{cL}^{\left(1\right)} sinh \left({\overline{γ}}_{L}^{\left(1\right)}{l}_{MP}\right)$ (1) ${\overline{V}}_{{N}_{1}}^{\left(1\right)} = {\overline{V}}_{N}^{\left(1\right)} cosh \left({\overline{γ}}_{L}^{\left(1\right)}{l}_{NQ}\right) - {\overline{I}}_{N}^{\left(1\right)} {\overline{z}}_{cL}^{\left(1\right)} sinh \left({\overline{γ}}_{L}^{\left(1\right)}{l}_{NQ}\right)$ (2)

Moreover, considering Fig. 4, the current flowing through the series capacitor from bus M and bus N can be computed as in equations (3) and (4), respectively. ${\overline{I}}_{{M}_{1}}^{\left(1\right)} = \frac{{\overline{V}}_{M}^{\left(1\right)}}{{\overline{z}}_{cL}^{\left(1\right)}} sinh \left({\overline{γ}}_{L}^{\left(1\right)}{l}_{MP}\right) - {\overline{I}}_{M}^{\left(1\right)} cosh \left({\overline{γ}}_{L}^{\left(1\right)}{l}_{MP}\right)$ (3) ${\overline{I}}_{{N}_{1}}^{\left(1\right)} = \frac{{\overline{V}}_{N}^{\left(1\right)}}{{\overline{z}}_{cL}^{\left(1\right)}} sinh \left({\overline{γ}}_{L}^{\left(1\right)}{l}_{NQ}\right) - {\overline{I}}_{N}^{\left(1\right)} cosh \left({\overline{γ}}_{L}^{\left(1\right)}{l}_{NQ}\right)$ (4) where ${\overline{V}}_{M}^{\left(1\right)}$ and ${\overline{I}}_{M}^{\left(1\right)}$ are the positive sequence voltage and current, respectively, seen by a relay at the bus M, ${\overline{V}}_{N}^{\left(1\right)}$ and ${\overline{I}}_{N}^{\left(1\right)}$ are the positive sequence voltage and current, respectively, seen by a relay at the bus N, ${\overline{z}}_{cL}^{\left(1\right)}$ is the characteristic impedance of the line, ${\overline{γ}}_{L}^{\left(1\right)}$ is the propagation constant of the line, *l_{MP}* is the length of the line from bus M to point P and *l_{NQ}* is the length of the line from point Q to bus N.

The relationship between the computed voltage and currents from bus M and bus N are: ${\overline{V}}_{{N}_{1}}^{\left(1\right)} = {\overline{V}}_{{M}_{1}}^{\left(1\right)} - {\overline{I}}_{{M}_{1}}^{\left(1\right)} ∗ {jX}_{c}$ (5) ${I}_{{M}_{1}}^{\left(1\right)} = - {I}_{{N}_{1}}^{\left(1\right)}$ (6)

By substituting ${\overline{I}}_{{M}_{1}}^{\left(1\right)}$ and ${\overline{I}}_{{N}_{1}}^{\left(1\right)}$ in (6), the following is obtained. $\frac{{\overline{V}}_{M}^{\left(1\right)}}{{\overline{z}}_{cL}^{\left(1\right)}} sinh \left({\overline{γ}}_{L}^{\left(1\right)}{l}_{MP}\right) - {\overline{I}}_{M}^{\left(1\right)} cosh \left({\overline{γ}}_{L}^{\left(1\right)}{l}_{MP}\right) = - \frac{{\overline{V}}_{N}^{\left(1\right)}}{{\overline{z}}_{cL}^{\left(1\right)}} sinh \left({\overline{γ}}_{L}^{\left(1\right)}{l}_{NQ}\right) + {\overline{I}}_{N}^{\left(1\right)} cosh \left({\overline{γ}}_{L}^{\left(1\right)}{l}_{NQ}\right)$ (7) ${\overline{z}}_{cL}^{\left(1\right)} = \frac{{\overline{V}}_{M}^{\left(1\right)} sinh \left({\overline{γ}}_{L}^{\left(1\right)}{l}_{MP}\right) + {\overline{V}}_{N}^{\left(1\right)} \left(sinh {\overline{γ}}_{L}^{\left(1\right)}{l}_{NQ}\right)}{{\overline{I}}_{M}^{\left(1\right)} cosh \left({\overline{γ}}_{L}^{\left(1\right)}{l}_{MP}\right) + {\overline{I}}_{N}^{\left(1\right)} cosh \left({\overline{γ}}_{L}^{\left(1\right)}{l}_{NQ}\right)}$ (8)

By substituting ${\overline{z}}_{cL}^{\left(1\right)}$ in the other equations and simplifying, the following is obtained. $\begin{matrix}\frac{{\overline{V}}_{N}^{\left(1\right)} {\overline{I}}_{N}^{\left(1\right)} - {\overline{V}}_{M}^{\left(1\right)} {\overline{I}}_{M}^{\left(1\right)} + cosh \left({\overline{γ}}_{L}^{\left(1\right)}{l}_{MN}\right) ∗ \left({\overline{V}}_{N}^{\left(1\right)}{\overline{I}}_{M}^{\left(1\right)}-{\overline{V}}_{M}^{\left(1\right)}-{\overline{V}}_{M}^{\left(1\right)}{\overline{I}}_{N}^{\left(1\right)}\right)}{\left({\overline{I}}_{M}^{\left(1\right)}cosh\left({\overline{γ}}_{L}^{\left(1\right)}{l}_{MP}\right)+{\overline{I}}_{N}^{\left(1\right)} cosh\left({\overline{γ}}_{L}^{\left(1\right)}{l}_{NQ}\right)\right)} = \\ - {jX}_{c} \left[\frac{{\overline{V}}_{M}^{\left(1\right)} {\overline{I}}_{N}^{\left(1\right)} sinh \left({\overline{γ}}_{L}^{\left(1\right)}{l}_{MP}\right) ∗ cosh \left({\overline{γ}}_{L}^{\left(1\right)}{l}_{NQ}\right) - {\overline{V}}_{N}^{\left(1\right)} {\overline{I}}_{M}^{\left(1\right)} cosh \left({\overline{γ}}_{L}^{\left(1\right)}{l}_{MP}\right) ∗ sinh \left({\overline{γ}}_{L}^{\left(1\right)}{l}_{NQ}\right)}{{\overline{V}}_{M}^{\left(1\right)} sinh \left({\overline{γ}}_{L}^{\left(1\right)}{l}_{MP}\right) + {\overline{V}}_{N}^{\left(1\right)} sinh \left({\overline{γ}}_{L}^{\left(1\right)}{l}_{NQ}\right)}\right]\end{matrix}$ (9)

By expanding the hyperbolic functions using Taylor series and approximating them, the following is obtained.

By simplifying formula (9), the following formula is obtained. ${Hγ}^{6} + \left(G-C\right) {γ}^{4} + \left(F-B\right) {γ}^{2} + E - A = 0$ (10) Where, $H = - {jX}_{c} \left[\frac{{\overline{V}}_{M}^{\left(1\right)} {\overline{I}}_{M}^{\left(1\right)} {\overline{I}}_{N}^{\left(1\right)} {l}_{MP}^{5} {l}_{NQ}^{2}}{24}+\frac{{\overline{V}}_{M}^{\left(1\right)} {\overline{I}}_{N}^{{\left(1\right)}^{2}} {l}_{MP}^{3} {l}_{NQ}^{4}}{24}-\frac{{\overline{V}}_{N}^{\left(1\right)} {\overline{I}}_{M}^{{\left(1\right)}^{2}} {l}_{MP}^{4} {l}_{NQ}^{3}}{24}-\frac{{\overline{V}}_{N}^{\left(1\right)} {\overline{I}}_{M}^{\left(1\right)} {\overline{I}}_{N}^{\left(1\right)} {l}_{MP}^{2} {l}_{NQ}^{5}}{24}\right]$ $G = - {jX}_{c} \left[\begin{matrix}\frac{4 {\overline{V}}_{M}^{\left(1\right)} {\overline{I}}_{M}^{\left(1\right)} {\overline{I}}_{N}^{\left(1\right)} {l}_{MP}^{3} {l}_{NQ}^{2}}{12} + \frac{{\overline{V}}_{M}^{\left(1\right)} {\overline{I}}_{M}^{\left(1\right)} {\overline{I}}_{N}^{\left(1\right)} {l}_{MP}^{5}}{12} + \\ \frac{2 {\overline{V}}_{M}^{\left(1\right)} {\overline{I}}_{N}^{{\left(1\right)}^{2}} {l}_{MP}^{3} {l}_{NQ}^{2}}{12} + \frac{3 {\overline{V}}_{M}^{\left(1\right)} {\overline{I}}_{N}^{{\left(1\right)}^{2}} {l}_{MP} {l}_{NQ}^{4}}{12} - \frac{2 {\overline{V}}_{N}^{\left(1\right)} {\overline{I}}_{M}^{{\left(1\right)}^{2}} {l}_{MP}^{2} {l}_{NQ}^{3}}{12} - \\ \frac{3 {\overline{V}}_{N}^{\left(1\right)} {\overline{I}}_{M}^{{\left(1\right)}^{2}} {l}_{MP}^{4} {l}_{NQ}}{12} - \frac{4 {\overline{V}}_{N}^{\left(1\right)} {\overline{I}}_{M}^{\left(1\right)} {\overline{I}}_{N}^{\left(1\right)} {l}_{MP}^{2} {l}_{NQ}^{3}}{12} - \frac{{\overline{V}}_{N}^{\left(1\right)} {\overline{I}}_{M}^{\left(1\right)} {\overline{I}}_{N}^{\left(1\right)} {l}_{NQ}^{5}}{12}\end{matrix}\right]$ $F = - {jX}_{c} \left[\begin{matrix}\frac{3 {\overline{V}}_{M}^{\left(1\right)} {\overline{I}}_{M}^{\left(1\right)} {\overline{I}}_{N}^{\left(1\right)} {l}_{MP} {l}_{NQ}^{2}}{6} + \frac{4 {\overline{V}}_{M}^{\left(1\right)} {\overline{I}}_{M}^{\left(1\right)} {\overline{I}}_{N}^{\left(1\right)} {l}_{MP}^{3}}{6} + \frac{6 {\overline{V}}_{M}^{\left(1\right)} {\overline{I}}_{N}^{{\left(1\right)}^{2}} {l}_{MP} {l}_{NQ}^{2}}{6} + \frac{{\overline{V}}_{M}^{\left(1\right)} {\overline{I}}_{N}^{{\left(1\right)}^{2}} {l}_{MP}^{3}}{6} - \frac{{\overline{V}}_{N}^{\left(1\right)} {\overline{I}}_{M}^{{\left(1\right)}^{2}} {l}_{NQ}^{3}}{6} - \\ \frac{6 {\overline{V}}_{N}^{\left(1\right)} {\overline{I}}_{M}^{{\left(1\right)}^{2}} {l}_{MP}^{2} {l}_{NQ}}{6} - \frac{{\overline{V}}_{N}^{\left(1\right)} {\overline{I}}_{M}^{\left(1\right)} {\overline{I}}_{N}^{\left(1\right)} {l}_{NQ}^{3}}{6} - \frac{3 {\overline{V}}_{N}^{\left(1\right)} {\overline{I}}_{M}^{\left(1\right)} {\overline{I}}_{N}^{\left(1\right)} {l}_{MP}^{2} {l}_{NQ}}{6} - \frac{3 {\overline{V}}_{N}^{\left(1\right)} {\overline{I}}_{M}^{\left(1\right)} {\overline{I}}_{N}^{\left(1\right)} {l}_{NQ}^{3}}{6}\end{matrix}\right]$ $E = - {jX}_{c} \left[{\overline{V}}_{M}^{\left(1\right)}{\overline{I}}_{M}^{\left(1\right)}{\overline{I}}_{N}^{\left(1\right)}{l}_{MP}+{\overline{V}}_{M}^{\left(1\right)}{{\overline{I}}_{N}^{\left(1\right)}}^{{}^{2}}{l}_{MP}-{\overline{V}}_{N}^{\left(1\right)}{{\overline{I}}_{M}^{\left(1\right)}}^{{}^{2}}{l}_{NQ}-{\overline{V}}_{N}^{\left(1\right)}{\overline{I}}_{M}^{\left(1\right)}{\overline{I}}_{N}^{\left(1\right)}{l}_{NQ}\right]$ $\text{C} = \frac{{l}_{M N}^{2} \left[{\overline{V}}_{M}^{\left(1\right)} {\overline{V}}_{N}^{\left(1\right)} {\overline{I}}_{N}^{\left(1\right)} {l}_{M P}^{3} + {\overline{V}}^{2} {}_{N}^{\left(1\right)} {\overline{I}}_{M}^{\left(1\right)} {l}_{N Q}^{3} - {\overline{V}}^{2} {}_{M}^{\left(1\right)} {\overline{I}}_{N}^{\left(1\right)} {l}_{1}^{3} - {\overline{V}}_{M}^{\left(1\right)} {\overline{V}}_{N}^{\left(1\right)} {\overline{I}}_{N}^{\left(1\right)} {l}_{N Q}^{3}\right]}{12}$ $\begin{matrix}\text{B} = \\ \frac{{\overline{V}}_{M}^{\left(1\right)} {\overline{V}}_{N}^{\left(1\right)} {\overline{I}}_{N}^{\left(1\right)} {l}_{M P}^{3} + {\overline{V}}^{2} {}_{N}^{\left(1\right)} {\overline{I}}_{N}^{\left(1\right)} {l}_{N Q}^{3} - {\overline{V}}^{2} {}_{M}^{\left(1\right)} {\overline{I}}_{M}^{\left(1\right)} {l}_{M P}^{3} - {\overline{V}}_{M}^{\left(1\right)} {\overline{V}}_{N}^{\left(1\right)} {\overline{I}}_{M}^{\left(1\right)} {l}_{N Q}^{3} + {\overline{V}}_{M}^{\left(1\right)} {\overline{V}}_{N}^{\left(1\right)} {\overline{I}}_{M}^{\left(1\right)} {l}_{M P}^{3} + {\overline{V}}^{2} {}_{N}^{\left(1\right)} {\overline{I}}_{M}^{\left(1\right)} {l}_{N Q}^{3} - {\overline{V}}^{2} {}_{M}^{\left(1\right)} {\overline{I}}_{N}^{\left(1\right)} {l}_{M P}^{3} - {\overline{V}}_{M}^{\left(1\right)} {\overline{V}}_{N}^{\left(1\right)} {\overline{I}}_{N}^{\left(1\right)} {l}_{N Q}^{3}}{6} + \\ \frac{3 {l}_{M N}^{2} \left[{\overline{V}}_{M}^{\left(1\right)} {\overline{V}}_{N}^{\left(1\right)} {\overline{I}}_{M}^{\left(1\right)} {l}_{1} + {\overline{V}}^{2} {}_{N}^{\left(1\right)} {\overline{I}}_{M}^{\left(1\right)} {l}_{N Q} - {\overline{V}}^{2} {}_{M}^{\left(1\right)} {\overline{I}}_{N}^{\left(1\right)} {l}_{M P} - {\overline{V}}_{M}^{\left(1\right)} {\overline{V}}_{N}^{\left(1\right)} {\overline{I}}_{N}^{\left(1\right)} {l}_{N Q}\right]}{6}\end{matrix}$ $\begin{matrix}\text{A} = {\overline{V}}_{M}^{\left(1\right)} {\overline{V}}_{N}^{\left(1\right)} {\overline{I}}_{N}^{\left(1\right)} {l}_{M P} + {\overline{V}}^{2} {}_{N}^{\left(1\right)} {\overline{I}}_{N}^{\left(1\right)} {l}_{N Q} - {\overline{V}}^{2} {}_{M}^{\left(1\right)} {\overline{I}}_{M}^{\left(1\right)} {l}_{M P} - {\overline{V}}_{M}^{\left(1\right)} {\overline{V}}_{N}^{\left(1\right)} {\overline{I}}_{N}^{\left(1\right)} {l}_{N Q} + {\overline{V}}_{M}^{\left(1\right)} {\overline{V}}_{N}^{\left(1\right)} {\overline{I}}_{M}^{\left(1\right)} {l}_{M Q} + \\ {\overline{V}}^{2} {}_{N}^{\left(1\right)} {\overline{I}}_{M}^{\left(1\right)} {l}_{N Q} - {\overline{V}}^{2} {}_{M}^{\left(1\right)} {\overline{I}}_{N}^{\left(1\right)} {l}_{M P} - {\overline{V}}_{M}^{\left(1\right)} {\overline{V}}_{N}^{\left(1\right)} {\overline{I}}_{N}^{\left(1\right)} {l}_{N Q}\end{matrix}$

Equation (10) can be formulated as a cubic equation as in (11), ${Hδ}^{3} + \left(G-C\right) {δ}^{2} + \left(F-B\right) δ + E - A = 0$ (11) Where, *δ* = *γ*².

Equation (11) can be expressed as: $P {δ}^{3} + {Qδ}^{2} + Rδ + S = 0$ (12)

The roots of the cubic equation (12) (*α, β*, *ω*) can be expressed as in (14): $\begin{matrix}α = \frac{- \left(Q+uK+\frac{{Δ}_{0}}{uK}\right)}{3 P} \\ β = \frac{- \left(Q+{u}^{2}K+\frac{{Δ}_{0}}{{u}^{2} K}\right)}{3 P} \\ ω = \frac{- \left(Q+{u}^{3}K+\frac{{Δ}_{0}}{{u}^{3} K}\right)}{3 P}\end{matrix}$ (13) where, ${Δ}_{0} = {Q}^{2} - 3 PR$ ${Δ}_{1} = 2 {Q}^{3} - 9 PQR + 27 {P}^{2} S$ $K = \sqrt[3]{\frac{\sqrt{\left({Δ}_{1}^{2}-4{Δ}_{0}^{3}\right)} + {Δ}_{1}}{2}}$ $u = \frac{- 1 + \sqrt{- 3}}{2}$

From (13) (*α, β*, *ω*), six values of *γ*, as expressed in (14), may be obtained. $\begin{matrix}{γ}_{1 , 2} = \pm \sqrt{α} \\ {γ}_{3 , 4} = \pm \sqrt{β} \\ {γ}_{5 , 6} = \pm \sqrt{ω}\end{matrix}$ (14)

Corresponding to each *γ*, six values of *Z_{c}* may be obtained from (8): ${Z}_{{c}_{m}} = \frac{{\overline{V}}_{M}^{\left(1\right)} sinh \left({\overline{γ}}_{m}^{\left(1\right)}{l}_{MP}\right) + {\overline{V}}_{N}^{\left(1\right)} sinh \left({\overline{γ}}_{m}^{\left(1\right)}{l}_{NQ}\right)}{{\overline{I}}_{M}^{\left(1\right)} cosh \left({\overline{γ}}_{m}^{\left(1\right)}{l}_{MP}\right) + {\overline{I}}_{N}^{\left(1\right)} cosh \left({\overline{γ}}_{m}^{\left(1\right)}{l}_{NQ}\right)} , wherein m = 1 , 2 , … , 6$ (15)

The valid solution of *γ* and *Z_{c}* and R, *X_{L}* and Y can be obtained from the below mentioned conditions as in (16). $real \left({γ}_{m}^{2}\right) < 0 and real \left({Z}_{{c}_{m}}^{2}\right) > 0$ $imag \left({γ}_{m}^{2}\right) > 0$ *and* $imag \left({Z}_{{c}_{m}}^{2}\right) < 0$ $R > 0 {X}_{L} > 0 and Y > 0$ (16)

From the valid solution of *γ* and *Z_{c}*, the line parameters R, X and Y can be derived as below.

The characteristic impedance *Z_{c}* and propagation constant *γ* can be expressed in terms of the positive sequence impedance (Z) and the positive sequence admittance (Y) as in equation (17). ${Z}_{c} = \sqrt{\frac{Z}{Y}} , γ = \sqrt{ZY}$ (17)

Equation (17) can be simplified as follows (equation (18)). ${Z}_{c}^{2} = \frac{Z}{Y} , {γ}^{2} = ZY$ (18)

Equation (18) can be further simplified: ${Z}^{2} = {Z}_{c}^{2} {γ}^{2}$ (19)

The line impedance (Z) can be computed from equation (19) to obtain: $Z = \sqrt{{Z}_{c}^{2} {γ}^{2}}$ (20)

The line resistance (R) and inductive reactance *(X_{L})* can be computed from equation (20) to obtain equation (21) $R = real \left(Z\right) , {X}_{L} = imag \left(Z\right)$ (21)

From equation, (19), the line admittance can be computed as: ${Y}^{2} = \frac{{γ}^{2}}{{Z}_{c}^{2}} = > Y = \sqrt{\frac{{γ}^{2}}{{Z}_{c}^{2}}}$ (22)

The susceptance (B) of the line can be obtained as: $B = imag \left(Y\right)$ (23)

The estimated parameters can be used to compute the wave velocity as per equation (24). $v = \frac{2 ∗ pi ∗ f}{abs \left(γ\right)}$ (24)

The same method can be used for series compensation at one end or both ends of the line.

The following relates to the method as described above, extended to a series compensator at one end.

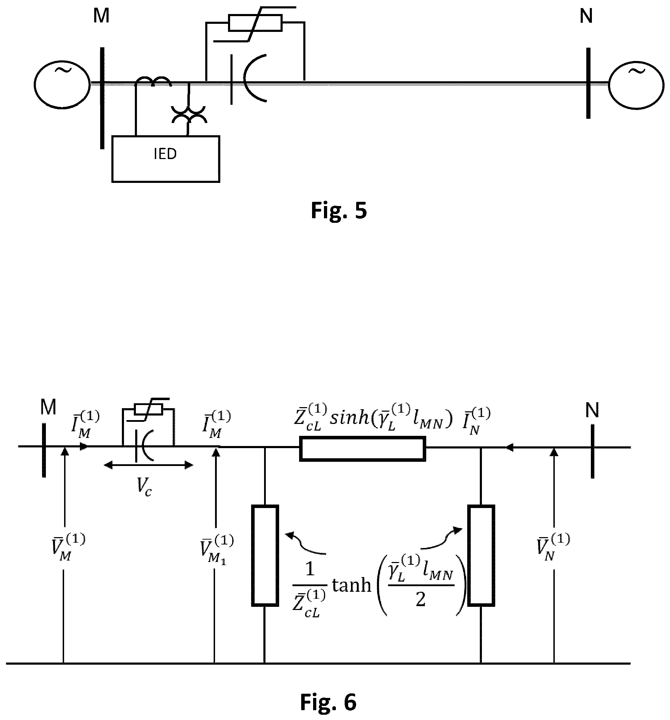

Fig. 5 shows a single line diagram of a two terminal transmission line (buses M/N) with a series compensator present at one end (bus M). The pre-fault network for the system in Fig. 5 is shown in Fig. 6.

The positive sequence voltage from bus M can be computed using bus N measurements as in equation (25). ${\overline{V}}_{M}^{\left(1\right)} - {V}_{c} = {\overline{V}}_{{M}_{1}}^{\left(1\right)} = {\overline{V}}_{N}^{\left(1\right)} cosh \left({\overline{γ}}_{L}^{\left(1\right)}{l}_{MN}\right) - {\overline{I}}_{N}^{\left(1\right)} {\overline{z}}_{cL}^{\left(1\right)} sinh \left({\overline{γ}}_{L}^{\left(1\right)}{l}_{MN}\right)$ (25) where ${V}_{c} = {\overline{I}}_{M}^{\left(1\right)} ∗ - {jX}_{c}$ (26)

Similarly, the positive sequence current from bus M can be computed using bus N measurements as in equation (27). ${\overline{I}}_{M}^{\left(1\right)} = \frac{{\overline{V}}_{N}^{\left(1\right)}}{{\overline{z}}_{cL}^{\left(1\right)}} sinh \left({\overline{γ}}_{L}^{\left(1\right)}{l}_{MN}\right) - {\overline{I}}_{N}^{\left(1\right)} cosh \left({\overline{γ}}_{L}^{\left(1\right)}{l}_{MN}\right)$ (27) where ${\overline{Z}}_{cL}^{\left(1\right)} = \sqrt{\frac{{R}_{L}^{\left(1\right)} + {jX}_{L}^{\left(1\right)}}{{jX}_{C}^{\left(1\right)}}} , {\overline{γ}}_{L}^{\left(1\right)} = \sqrt{\left({R}_{L}^{\left(1\right)}+{jX}_{L}^{\left(1\right)}\right) ∗ {jX}_{C}^{\left(1\right)}} .$

Here, ${R}_{L}^{\left(1\right)} , {X}_{L}^{\left(1\right)}$ and ${X}_{c}^{\left(1\right)}$ are the positive sequence per unit length resistance, inductive and capacitive reactance of the line, respectively.

By simplifying the equations (25), (26) and (27), ${\overline{γ}}_{L}^{\left(1\right)}$ can be estimated as in equations (28) and (29). ${\overline{γ}}_{L}^{\left(1\right)} = \frac{{cosh}^{- 1} \left({\overline{A}}_{1}+{\overline{A}}_{2}\right)}{{l}_{MN}}$ (28) where ${\overline{A}}_{1} = \frac{{\overline{V}}_{{M}_{1}}^{\left(1\right)} {\overline{I}}_{M}^{\left(1\right)}}{{\overline{V}}_{N}^{\left(1\right)} {\overline{I}}_{M}^{\left(1\right)} - {\overline{V}}_{{M}_{1}}^{\left(1\right)} {\overline{I}}_{N}^{\left(1\right)}} , {\overline{A}}_{2} = \frac{- {\overline{V}}_{N}^{\left(1\right)} {\overline{I}}_{N}^{\left(1\right)}}{{\overline{V}}_{N}^{\left(1\right)} {\overline{I}}_{M}^{\left(1\right)} - {\overline{V}}_{{M}_{1}}^{\left(1\right)} {\overline{I}}_{N}^{\left(1\right)}}$ (29)

Moreover, ${\overline{Z}}_{cL}^{\left(1\right)}$ can be computed using ${\overline{γ}}_{L}^{\left(1\right)}$ from equation (30): ${\overline{Z}}_{cL}^{\left(1\right)} = \frac{\left({\overline{V}}_{N}^{\left(1\right)}cosh\left({\overline{γ}}_{L}^{\left(1\right)}{l}_{MN}\right)-{\overline{V}}_{M}^{\left(1\right)}\right)}{{\overline{I}}_{N}^{\left(1\right)} sinh \left({\overline{γ}}_{L}^{\left(1\right)}{l}_{MN}\right)}$ (30)

Hence, the parameters of the line shown in Fig. 5 can be computed using the estimated ${\overline{γ}}_{L}^{\left(1\right)} , {\overline{Z}}_{cL}^{\left(1\right)}$ of equations (28) and (30). Also, the wave propagation velocity can be obtained from equation (24) using ${\overline{γ}}_{L}^{\left(1\right)}$ obtained as above.

Moreover, the method outlined above can be extended to series compensators at both ends.

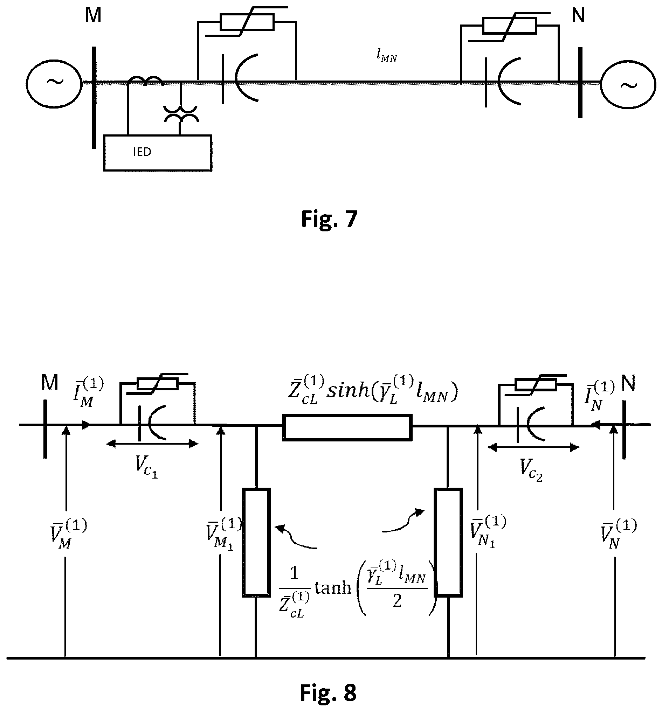

Fig. 7 shows a single line diagram of a two terminal transmission line (buses M/N) with series compensators present at both ends (bus M and bus N). The pre-fault network for the system of Fig. 7 is shown in Fig. 8.

The positive sequence voltage from bus M can be computed using bus N measurements as in equation (31). ${\overline{V}}_{{M}_{1}}^{\left(1\right)} = {\overline{V}}_{{N}_{1}}^{\left(1\right)} cosh \left({\overline{γ}}_{L}^{\left(1\right)}{l}_{MN}\right) - {\overline{I}}_{N}^{\left(1\right)} {\overline{z}}_{cL}^{\left(1\right)} sinh \left({\overline{γ}}_{L}^{\left(1\right)}{l}_{MN}\right)$ (31) where ${V}_{{c}_{1}} = {\overline{I}}_{M}^{\left(1\right)} ∗ - {jX}_{c} , {V}_{{c}_{2}} = {\overline{I}}_{N}^{\left(1\right)} ∗ - {jX}_{c} {\overline{V}}_{{M}_{1}}^{\left(1\right)} = {\overline{V}}_{M}^{\left(1\right)} - {V}_{{c}_{1}} , {\overline{V}}_{{N}_{1}}^{\left(1\right)} = {\overline{V}}_{N}^{\left(1\right)} - {V}_{{c}_{2}}$ (32)

Similarly, the positive sequence current from bus M can be computed using bus N measurements as in equation (33). ${\overline{I}}_{M}^{\left(1\right)} = \frac{{\overline{V}}_{{N}_{1}}^{\left(1\right)}}{{\overline{z}}_{cL}^{\left(1\right)}} sinh \left({\overline{γ}}_{L}^{\left(1\right)}{l}_{MN}\right) - {\overline{I}}_{N}^{\left(1\right)} cosh \left({\overline{γ}}_{L}^{\left(1\right)}{l}_{MN}\right)$ (33) where ${\overline{Z}}_{cL}^{\left(1\right)} = \sqrt{\frac{{R}_{L}^{\left(1\right)} + {jX}_{L}^{\left(1\right)}}{{jX}_{C}^{\left(1\right)}}} , {\overline{γ}}_{L}^{\left(1\right)} = \sqrt{\left({R}_{L}^{\left(1\right)}+{jX}_{L}^{\left(1\right)}\right) ∗ {jX}_{C}^{\left(1\right)}}$

Here, ${R}_{L}^{\left(1\right)} , {X}_{L}^{\left(1\right)}$ and ${X}_{c}^{\left(1\right)}$ are the positive sequence per unit length resistance, inductive and capacitive reactance of the line, respectively.

By simplifying the equations (31), (32) and (33), ${\overline{γ}}_{L}^{\left(1\right)}$ can be estimated as in equations (34) and (35) below. ${\overline{γ}}_{L}^{\left(1\right)} = \frac{{cosh}^{- 1} \left({\overline{A}}_{1}+{\overline{A}}_{2}\right)}{{l}_{MN}}$ (34) where ${\overline{A}}_{1} = \frac{{\overline{V}}_{{M}_{1}}^{\left(1\right)} {\overline{I}}_{M}^{\left(1\right)}}{{\overline{V}}_{{N}_{1}}^{\left(1\right)} {\overline{I}}_{M}^{\left(1\right)} - {\overline{V}}_{{M}_{1}}^{\left(1\right)} {\overline{I}}_{N}^{\left(1\right)}} , {\overline{A}}_{2} = \frac{- {\overline{V}}_{{N}_{1}}^{\left(1\right)} {\overline{I}}_{N}^{\left(1\right)}}{{\overline{V}}_{{N}_{1}}^{\left(1\right)} {\overline{I}}_{M}^{\left(1\right)} - {\overline{V}}_{{M}_{1}}^{\left(1\right)} {\overline{I}}_{N}^{\left(1\right)}}$ (35)

Moreover, ${\overline{Z}}_{cL}^{\left(1\right)}$ can be computed using ${\overline{γ}}_{L}^{\left(1\right)}$ obtained from equation (34): ${\overline{Z}}_{cL}^{\left(1\right)} = \frac{\left({\overline{V}}_{{N}_{1}}^{\left(1\right)}cosh\left({\overline{γ}}_{L}^{\left(1\right)}{l}_{MN}\right)-{\overline{V}}_{{M}_{1}}^{\left(1\right)}\right)}{{\overline{I}}_{N}^{\left(1\right)} sinh \left({\overline{γ}}_{L}^{\left(1\right)}{l}_{MN}\right)}$ (36)

Hence, the parameters of the line shown in Fig. 7 can be computed using the estimated ${\overline{γ}}_{L}^{\left(1\right)} , {\overline{Z}}_{cL}^{\left(1\right)}$ using equations (34) and (36). Also, the wave propagation velocity can be obtained from equation (24) using ${\overline{γ}}_{L}^{\left(1\right)}$ obtained above.

Moreover, a fault location may be determined using the estimated wave speed.

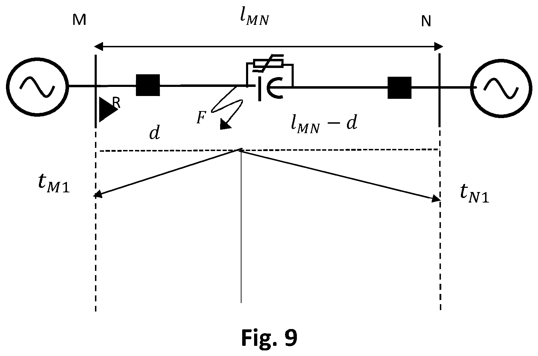

Considering a two terminal transmission line with series compensator present at the middle of the transmission line as shown in Fig. 3, an exemplary Bewley Lattice diagram for the system is shown in Fig. 9. Therein, the triangular box indicates a relay or a device such as an IED. The method described herein may be implemented at this relay or device. The rectangular box indicates a circuit breaker or a switch.

The arrival times recorded from bus M and bus N can be expressed as in equations (37) and (38). ${t}_{{M}_{1}} = {t}_{0} + \frac{d}{v}$ (37) ${t}_{N} = {t}_{0} + \frac{{l}_{MN} - d}{v}$ (38) where d is the location of fault from bus M, v is the wave speed, *l_{MN}* is the length of the transmission line, and *t*_{*M*₁}, *t*_{*N*₁} are the first arrival times recorded from bus M and bus N, respectively.

By simplifying (37) and (38), the fault location d can be obtained as $d = \frac{1}{2} \left({l}_{MN}+\left({t}_{{M}_{1}}-{t}_{{N}_{1}}\right)∗v\right)$ (39).

Here, the wave speed (v) estimated using equation (24) is used in equation (39) to obtain the fault location of the series compensated line without any settings. Therefore, a setting free fault location method using the estimated wave speed is obtained.

The device and computer-readable storage medium are configured to perform and store, respectively, the method as outlined above. The device may comprise at least one processor or the like and preferably a memory for storing respective instructions. The device may be an Intelligent Electronic Device (IED).

The present disclosure also relates to a power grid comprising a transmission line connected between two buses and the above device.

According to the present disclosure, a method to estimate the parameters of series compensated lines is presented. In particular, the method may be used for compensators located at the middle, one end or both ends of the line.

According to the disclosure, the following features and advantages may be achieved, although not limited to the following.

An estimation of parameters and wave speed of the series compensated line using both end pre-fault voltage and current measurements may be obtained.

The disclosure does not require any iterative approach to estimate the parameters. The parameters can be estimated for a series compensator located at any location of the line. The estimated parameters are very accurate with less than 1% accuracy for reactance and susceptance. The estimated wave speed can be used to compute the accurate fault location using first traveling wave arrival time. This approach eliminates the settings and dependency in second arrival time (reflected or refracted wave) for fault location calculation. This provides a reliable and robust fault location solution for series compensated lines.

The disclosure does not need any settings, thereby reducing the engineering effort.

The presented accurate fault locator can help the end users (Electric Utilities), e.g., to fix the network faults efficiently and restore power transmission line quickly, to improve overall network availability and reliability, to reduce repair and restoration cost for utilities and consequently, reduced power bills for end customers, to avoid high-cost patrolling methods like helicopter and drone search and/or to avoid unsafe crew patrolling, especially in difficult geographical terrains thereby Improve safety of the field staff.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any one of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any one of a variety of different technologies and techniques. For example, data, instructions, commands, information, signals, bits and symbols, for example, which may be referenced in the above description can be represented by voltages, currents, electromagnetic waves, magnetic fields or particles, optical fields or particles, or any combination thereof.

A skilled person would further appreciate that any one of the various illustrative logical blocks, units, processors, means, circuits, methods and functions described in connection with the aspects disclosed herein can be implemented by electronic hardware (e.g., a digital implementation, an analog implementation, or a combination of the two), firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, circuits, and steps have been described above generally in terms of their functionality. Whether such functionality is implemented as hardware, firmware or software, or a combination of these techniques, depends upon the particular application and design constraints imposed on the overall system. Skilled artisans can implement the described functionality in various ways for each particular application, but such implementation decisions do not cause a departure from the scope of the present disclosure. In accordance with various embodiments, a processor, device, component, circuit, structure, machine, unit, etc. can be configured to perform one or more of the functions described herein. The term "configured to" or "configured for" as used herein with respect to a specified operation or function refers to a processor, device, component, circuit, structure, machine, unit, etc. that is physically constructed, programmed and/or arranged to perform the specified operation or function.

Furthermore, a skilled person would understand that various illustrative logical blocks, units, devices, components and circuits described herein can be implemented within or performed by an integrated circuit (IC) that can include a general purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general purpose processor can be a microprocessor, but in the alternative, the processor can be any conventional processor, controller, or state machine. A processor can also be implemented as a combination of computing devices, e.g., a combination of a DSP and a microprocessor, a plurality of microprocessors, one or more microprocessors in conjunction with a DSP core, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

Computer-readable media includes both computer storage media and communication media including any medium that can be enabled to transfer a computer program or code from one place to another. A storage media can be any available media that can be accessed by a computer. By way of example, and not limitation, such computer-readable media can include RAM, ROM, EEPROM, CD-ROM or other optical disk storage, magnetic disk storage or other magnetic storage devices, or any other medium that can be used to store desired program code in the form of instructions or data structures and that can be accessed by a computer.

In this document, the term "unit" as used herein, refers to software, firmware, hardware, and any combination of these elements for performing the associated functions described herein. Additionally, for purpose of discussion, the various units are described as discrete units; however, as would be apparent to one of ordinary skill in the art, two or more units may be combined to form a single unit that performs the associated functions according embodiments of the present disclosure.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable distribution of functionality between different functional units, processing logic elements or domains may be used without detracting from the present disclosure. For example, functionality illustrated to be performed by separate processing logic elements, or controllers, may be performed by the same processing logic element, or controller. Hence, references to specific functional units are only references to a suitable means for providing the described functionality, rather than indicative of a strict logical or physical structure or organization.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

### List of references

[1] CIGRE Working Group B5.10, "Protection, Control and Monitoring of Series Compensated Networks," e-CIGRE, 2010 [Online]. Available: https://e-cigre.org/publication/411-protection-control-and-monitoring-of-series-compensated-networks.
[2] E. O. Schweitzer, A. Guzman, M. V. Mynam, V. Skendzic, B. Kasztenny, and S. Marx, "Locating faults by the traveling waves they launch," in Proc.67th Annu. Conf. Protective Relay Eng., Nov. 2014, pp. 95-110.
[3] O. D. Naidu and A. K. Pradhan, "Model Free Traveling Wave Based Fault Location Method for Series Compensated Transmission Line," in IEEE Access, vol. 8, pp. 193128-193137, 2020, doi: 10.1109/ACCESS.2020.3032458.
[4] J. Ding, L. Li, Y. Zheng, C. Zhao, H. Chen and X. Wang, "Distributed travelling-wave-based fault location without time synchronization and wave velocity error," in IET Generation, Transmission & Distribution, vol. 11, no. 8, pp. 2085-2093, July 2017.
[5] F. V. Lopes, Dantas, K. M., Silva, K. M., and Costa, F. B. "Accurate two-terminal transmission line fault location using traveling waves", in IEEE Trans., Power Del., vol.33, pp.873-880, Apr.2018.
[6] Y. Zhang and Y. Liao, "Optimal Line Parameter Estimation Method For Mid-Compensated Transmission Lines," 2019 North American Power Symposium (NAPS), Wichita, KS, USA, 2019, pp. 1-6, doi: 10.1109/NAPS46351.2019.9000274.
[7] Y. Zhang and Y. Liao, "Series Compensated Transmission Line Parameter Estimation Based on Kalman Filter," 2020 SoutheastCon, Raleigh, NC, USA, 2020, pp. 1-7, doi: 10.1109/SoutheastCon44009.2020.9249656.
[8] S. S. Mousavi-Seyedi, F. Aminifar and S. Afsharnia, "Application of WAMS and SCADA Data to Online Modeling of Series-Compensated Transmission Lines," in IEEE Transactions on Smart Grid, vol. 8, no. 4, pp. 1968-1976, July 2017, doi: 10.1109/TSG.2015.2513378.
[9] S. Gajare, A. K. Pradhan and V. Terzija, "A Method for Accurate Parameter Estimation of Series Compensated Transmission Lines Using Synchronized Data," in IEEE Transactions on Power Systems, vol. 32, no. 6, pp. 4843-4850, Nov. 2017, doi: 10.1109/TPWRS.2017.2679542.

## Claims

1. Method for determining a wave speed or propagation velocity in a power grid comprising a transmission line connected between two buses, the method comprising:
obtaining (S21) a voltage and current at at least one bus,
determining (S22) a propagation constant and a characteristic impedance using the voltage, the current and a series compensator capacitance,
determining (S23) line parameters based on the propagation constant and the characteristic impedance, and
determining (S24) a wave speed or propagation velocity based on the line parameters.

2. Method according to claim 1, wherein the line parameters comprise a line inductance, a line capacitance, a line resistance and a line conductance.

3. Method according to claim 2, wherein the wave speed or propagation velocity is determined based on an inverse of a square root of the line inductance and the line capacitance.

4. Method according to any one of claims 1 to 3, wherein the propagation constant is determined based on a positive sequence current and voltage at the least one bus and a length between the at least one bus and a series compensator capacitance.

5. Method according to any one of claims 1 to 4, further comprising determining a traveling wave arrival time at at least one of the buses.

6. Method according to claim 5, further comprising determining a fault location based on a first travelling wave arrival time, a line length and the wave speed or propagation velocity.

7. Method according to claim 6, wherein the fault location is determined using current and voltage measurements during the fault.

8. Method according to any one of claims 1 to 4, wherein the wave speed or propagation velocity is determined based on pre-fault current and voltage measurements.

9. Computer-readable storage medium comprising instructions which, when executed by a processor, instruct the processor to perform the method according to any one of claims 1 to 8.

10. Device comprising a processor configured to perform the method according to any one of claims 1 to 8.

11. Power grid comprising a transmission line connected between two buses and a device according to claim 10.

## Patentansprüche

1. Verfahren zum Bestimmen einer Wellengeschwindigkeit oder Propagationsgeschwindigkeit in einem Stromnetz, das eine Übertragungsleitung umfasst, die zwischen zwei Bussen verbunden ist, wobei das Verfahren Folgendes umfasst:
Erhalten (S21) einer Spannung und eines Stroms an wenigstens einem Bus,
Bestimmen (S22) einer Propagationskonstante und einer charakteristischen Impedanz unter Verwendung der Spannung, des Stroms und einer Reihenkompensatorkapazität,
Bestimmen (S23) von Leitungsparametern basierend auf der Propagationskonstante und der charakteristischen Impedanz, und
Bestimmen (S24) einer Wellengeschwindigkeit oder Propagationsgeschwindigkeit basierend auf den Leitungsparametern.

2. Verfahren nach Anspruch 1, wobei die Leitungsparameter eine Leitungsinduktivität, eine Leitungskapazität, einen Leitungswiderstand und einen Leitungsleitwert umfassen.

3. Verfahren nach Anspruch 2, wobei die Wellengeschwindigkeit oder Propagationsgeschwindigkeit basierend auf einem Kehrwert einer Quadratwurzel der Leitungsinduktivität und der Leitungskapazität bestimmt wird.

4. Verfahren nach einem der Ansprüche 1 bis 3, wobei die Propagationskonstante basierend auf einem Mitsystemstrom und einer Mitsystemspannung an dem wenigstens einen Bus und einer Länge zwischen dem wenigstens einen Bus und einer Reihenkompensatorkapazität bestimmt wird.

5. Verfahren nach einem der Ansprüche 1 bis 4, das ferner Bestimmen einer Wanderwellenankunftszeit an wenigstens einem der Busse umfasst.

6. Verfahren nach Anspruch 5, das ferner Bestimmen eines Fehlerortes basierend auf einer ersten Wanderwellenankunftszeit, einer Leitungslänge und der Wellengeschwindigkeit oder Propagationsgeschwindigkeit umfasst.

7. Verfahren nach Anspruch 6, wobei der Fehlerort unter Verwendung von Strom- und Spannungsmessungen während des Fehlers bestimmt wird.

8. Verfahren nach einem der Ansprüche 1 bis 4, wobei die Wellengeschwindigkeit oder Propagationsgeschwindigkeit basierend auf Vorfehlerstrom- und -spannungsmessungen bestimmt wird.

9. Computerlesbares Speicherungsmedium, das Anweisungen umfasst, die, wenn sie durch einen Prozessor ausgeführt werden, den Prozessor dazu anweisen, das Verfahren nach einem der Ansprüche 1 bis 8 durchzuführen.

10. Vorrichtung, die einen Prozessor umfasst, der dazu konfiguriert ist, das Verfahren nach einem der Ansprüche 1 bis 8 durchzuführen.

11. Stromnetz, das eine zwischen zwei Bussen verbundene Übertragungsleitung und eine Vorrichtung nach Anspruch 10 umfasst.

## Revendications

1. Procédé de détermination d'une célérité d'onde ou vitesse de propagation dans un réseau électrique comprenant une ligne de transmission connectée entre deux bus, le procédé comprenant :
l'obtention (S21) d'une tension et d'un courant au niveau d'au moins un bus,
la détermination (S22) d'une constante de propagation et d'une impédance caractéristique à l'aide de la tension, du courant et d'une capacité de compensation en série,
la détermination (S23) de paramètres de ligne sur la base de la constante de propagation et de l'impédance caractéristique, et
la détermination (S24) d'une célérité d'onde ou d'une vitesse de propagation sur la base des paramètres de ligne.

2. Procédé selon la revendication 1, les paramètres de ligne comprenant une inductance de ligne, une capacité de ligne, une résistance de ligne et une conductance de ligne.

3. Procédé selon la revendication 2, la célérité d'onde ou la vitesse de propagation étant déterminée sur la base de l'inverse d'une racine carrée de l'inductance de ligne et de la capacité de ligne.

4. Procédé selon l'une quelconque des revendications 1 à 3, la constante de propagation étant déterminée sur la base d'un courant et d'une tension directs au niveau du ou des bus et d'une longueur entre le ou les bus et une capacité de compensation série.

5. Procédé selon l'une quelconque des revendications 1 à 4, comprenant en outre la détermination d'un temps d'arrivée d'onde progressive au niveau d'au moins l'un des bus.

6. Procédé selon la revendication 5, comprenant en outre la détermination d'un emplacement de défaut sur la base d'un premier temps d'arrivée d'onde progressive, d'une longueur de ligne et de la célérité d'onde ou de la vitesse de propagation.

7. Procédé selon la revendication 6, l'emplacement de défaut étant déterminé à l'aide de mesures de courant et de tension pendant le défaut.

8. Procédé selon l'une quelconque des revendications 1 à 4, la célérité d'onde ou la vitesse de propagation étant déterminée sur la base de mesures de courant et de tension avant le défaut.

9. Support de stockage lisible par ordinateur comprenant des instructions qui, lorsqu'elles sont exécutées par un processeur, ordonnent au processeur de réaliser le procédé selon l'une quelconque des revendications 1 à 8.

10. Dispositif comprenant un processeur configuré pour réaliser le procédé selon l'une quelconque des revendications 1 à 8.

11. Réseau électrique comprenant une ligne de transmission connectée entre deux bus et un dispositif selon la revendication 10.
